Europäisches Patentamt

European Patent Office

Office européen des brevets

(11) Veröffentlichungsnummer: **0 195 421 B1**

(12) # EUROPÄISCHE PATENTSCHRIFT

(45) Veröffentlichungstag der Patentschrift: **02.12.92**

(51) Int. Cl.5: **H04L 7/04**, H04L 7/10

(21) Anmeldenummer: **86103678.8**

(22) Anmeldetag: **18.03.86**

(54) Verfahren und Vorrichtung zur Synchronisation von digitalen Informationssignalen.

(30) Priorität: **22.03.85 DE 3510296**

(43) Veröffentlichungstag der Anmeldung:
**24.09.86 Patentblatt 86/39**

(45) Bekanntmachung des Hinweises auf die
Patenterteilung:
**02.12.92 Patentblatt 92/49**

(84) Benannte Vertragsstaaten:
**AT BE CH DE FR GB IT LI LU NL SE**

(56) Entgegenhaltungen:
EP-A- 0 165 619
FR-A- 2 547 139
US-A- 3 873 920

FUNKSCHAU, Nr. 4, Februar 1984, Seiten
39-42, München, DE; O. KLANK et al.:
"Satelliten-Tonrundfunk: Empfänger der Zukunft - ein Prototyp stellt sich vor"

(73) Patentinhaber: **TELEFUNKEN Fernseh und
Rundfunk GmbH
Göttinger Chaussee 76
W-3000 Hannover 91(DE)**

(72) Erfinder: **Klank, Otto, Dipl.-Ing.
Allensteiner Strasse 12
W-3160 Lehrte-Arpke(DE)**
Erfinder: **Rottmann, Dieter, Dipl.-Ing.
Girlitzpark 20
W-3000 Hannover 91(DE)**

(74) Vertreter: **Einsel, Robert, Dipl.-Ing.
TELEFUNKEN Fernseh und Rundfunk GmbH
Patent- und Lizenzabteilung Göttinger
Chaussee 76
W-3000 Hannover 91(DE)**

EP 0 195 421 B1

**Beschreibung**

Die Erfindung betrifft ein Verfahren und eine Vorrichtung zur Synchronisation von digitalen Informationssignalen gemäß dem Oberbegriff der Patentansprüche 1 und 10.

Bei der Übertragung von Nachrichten werden Signale einer Nachrichtenquelle entnommen und einem Wandler zugeführt, der die Signale in elektrische Signale umwandelt. Die elektrischen Signale werden an ein Sendegerät weitergeleitet, das die Signale moduliert. Über einen Nachrichtenkanal gelangen die modulierten Signale an ein Empfangsgerät. Im Empfangsgerät werden die Signale demoduliert und einem Wandler zugeführt, der die Daten für eine Nachrichtensinke wahrnehmbar macht. Bei einer Übertragung von digitalen Signalen werden auf der Empfängerseite die digitalen Signale im Wandler von einem Decoder verarbeitet.

Eine solche Übertragung ist in der NTZ Bd. 36 (1983) Heft 11 beschrieben. Dabei werden die Signale mit Hilfe einer Phasenumtastung (PSK, Phase Shift Keying) von einem Satelliten zu einem Empfänger übertragen und im Empfänger decodiert. Datenwörter in einem fehlerkorrigierenden Code und Synchronisationswörter werden übertragen. Bei der Synchronisation wird von einem Einschwingvorgang, nachdem aufeinanderfolgende Synchronworte erkannt worden sind, auf einen dauerhaften Betrieb in einem eingeschwungenen Zustand umgeschaltet. In einem Zeltfenster (engl. window) wird die Fehlerhäufigkeit des Synchronwortes überprüft. In Abhängigkeit von der Fehlerhäufigkeit des Synchronwortes wird entschieden, ob ein neuer Einschwingvorgang zur Suche nach einem Synchronwort in einer anderen Zeitperiode eingeleitet werden muß. Abstimmung bedeutet, die Fehlerhäufigkeit des Synchronwortes so hoch zuzulassen, daß erst bei nicht mehr korrigierbaren Übertragungsfehlern oder Totalausfall ein neuer Einschwingvorgang gestartet wird. Das wirkt sich insofern nachteilig aus, weil ein Zusammenhang zwischen gestörten Synchronisationswörtern und gestörten Datenwörtern hergestellt werden muß und dieser Zusammenhang muß so abgestimmt sein, daß die Fehlerhäufigkeit im Synchronwort erst dann als zu hoch angesehen wird, wenn auch die Dekodierung des Datenwortes keine verwertbaren Signale mehr ergibt.

Der Erfindung liegt die Aufgabe zugrunde, das Synchronisationsverfahren zu verbessern, insbesondere sollen Synchronisationswörter eingespart, die effektive Zeit für Datenworte gedehnt und der Störabstand vergrößert werden.

Diese Aufgabe wird durch die im Anspruch 1 angegebene Maßnahme gelöst. Vorteilhafte Weiterbildungen der Erfindung sind in Unteransprüchen genannt.

Weil im gestörten Nachrichtenkanal Störungen gleichmäßig verteilt sind, werden Synchronisationsworte und Datenworte gleichermaßen gestört. Wenn die Datenworte in einem Code übertragen werden, der die Datenworte selbständig korrigiert, so ist diese Korrektur ein Maß für die Störung im Nachrichtenkanal. Die Anzahl der Korrekturen, d.h. die Anzahl der korrigierbaren Bits in einem Datenwort, ist also ein Maß für eine vorliegende Störung in einem Nachrichtenkanal. Läßt sich eine Korrektur der Datenwörter über einen längeren Zeitraum nicht mehr vornehmen, so kann der Nachrichtenkanal als total gestört bezeichnet werden.

Die Erfindung nutzt diese Erkenntnis aus und zieht zur Bewertung der Störung aus einem Nachrichtenkanal nicht nur ein gestörtes Synchronisationswort, sondern gleichzeitig das korrigierbare Datenwort in Betracht. Eine gemeinsame Bewertung von Fehlerhäufigkeiten im Synchronisationswort und im Datenwort führt damit zu einem besseren Entscheidungskriterium über eine Störung im Nachrichtenkanal. Gleichzeitig kann die Zeit, die nötig ist, um eine Störung zu erkennen, reduziert werden.

Zum besseren Verständnis der Erfindung werden nachstehend Ausführungsbeispiele anhand von Zeichnungen näher erläutert.

Es zeigen

Figur 1      ein Nachrichtensystem,

Figur 2      Datenfolgen in einem Nachrichtensystem,

Figur 3      eine Schaltung für eine Synchronisationsworterkennung,

Figur 4      eine zweite Schaltung für eine Synchronisationsworterkennung,

Figur 5      eine Überwachungsschaltung für die Synchronisation,

Figur 6      eine Schaltung zur Durchführung von Concealments,

Figur 7      ein Blockschaltbild zur Synchronisationsworterkennung und

Figur 8      eine Schaltung zum Wechsel zwischen Einschwingvorgang und eingeschwungener Zustand

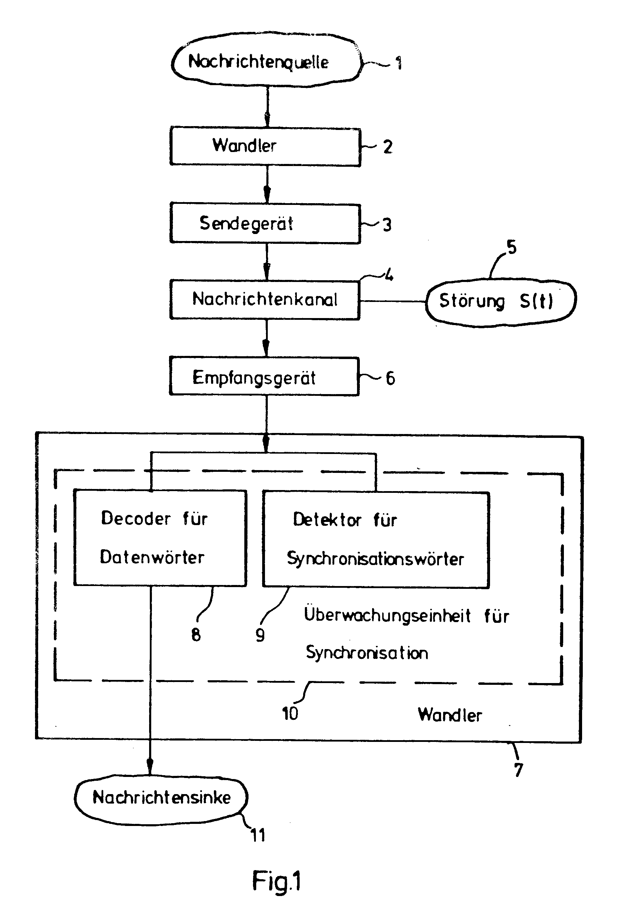

Figur 1 zeigt eine Nachrichtenquelle 1, einen Wandler 2, ein Sendegerät 3, einen Nachrichtenkanal 4, eine Störung 5, ein Empfangsgerät 6, einen Wandler 7, einen Decoder 8 für Datenwörter, einen Detektor 9 für Synchronisationswörter, eine Überwachungseinheit 10 für die Synchronisation und eine Nachrichtensinke 11. Im Wandler 7 werden Datenfolgen auf den Decoder 8 für Datenwörter und auf den Detektor 9 für Synchronisationswörter gegeben. Im Einschwingvorgang sucht der Detektor 9 Synchronisationswörter.

2

Erkennt der Detektor 9 mehrere Male hintereinander Synchronisationswörter in einem vorgegebenen Zeitrahmen, so wird auf einen eingeschwungenen Zustand umgeschaltet. In dem eingeschwungenen Zustand überwacht sowohl der Decoder 8 für Datenwörter als auch der Detektor 9 für Synchronisationswörter die Synchronisation. Die Überwachungseinheit 10 bewertet sowohl die Fehlerhäufigkeit der Datenwörter als auch die Fehlerhäufigkeit der Synchronisationswörter. Ist das Empfangsgerät 6 ein 4-PSK Demodulator, so werden zwei Unterrahmen (Kanal A, Kanal B), im folgenden Teilrahmen genannt, erzeugt, wobei beide Kanäle A, B an den Decoder 8 und beide Kanäle A, B an den Detektor 9 weitergeleitet werden.

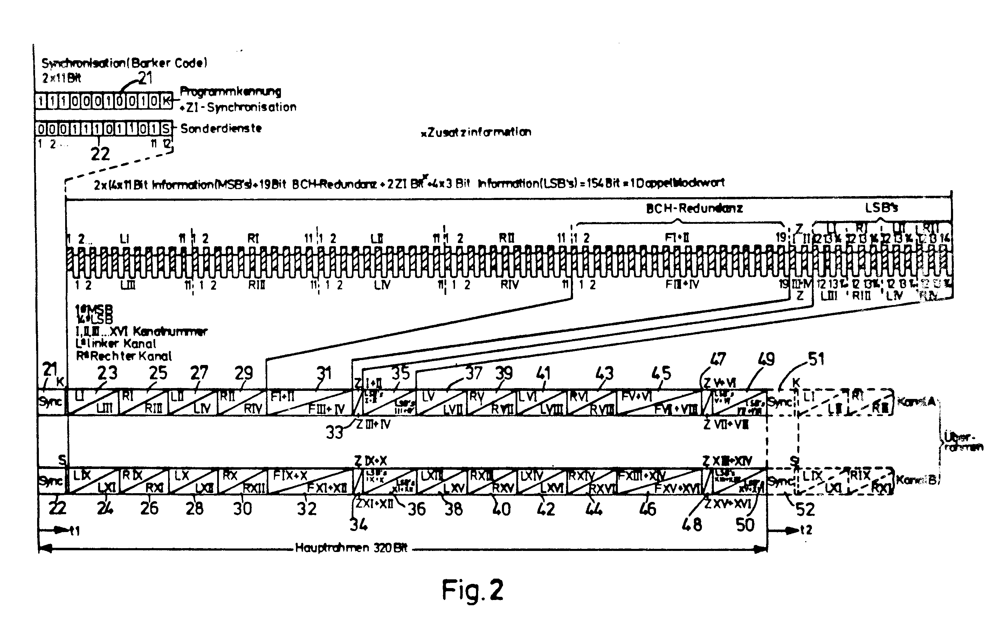

Figur 2 zeigt Datenfolgen mit Synchronisationswörtern 21,22,51 und 52 und mit Datenwörtern 23 - 50. Insgesamt sind 16 Programme I - XVI mit einem linken und einem rechten Kanal L, R vorgesehen. Die Datenwörter 23 - 30 und 37 - 44 beinhalten die MSB (Most Significant Bit, höherwertige Bits) von Abtastwerten. In den Datenwörtern 31,32 sind Parity Bits (Vergleich Bits) zur Fehlerkorrektur, in den Datenwörtern 33,34 sind Zusatzinformationen, u.a. ein Skalenfaktor, und in den Datenwörtern 35,36 die LSB (Last Significant Bits, niederwertige Bits) von Abtastwerten untergebracht. Der Skalenfaktor ist eine Codierung, die anzeigt, ob führende Nullen in einem Datenwort 23-30, 37-44 unterdrückt sind. Die beiden Kanäle A und B werden als Teilrahmen aus einem Hauptrahmen durch die Demodulation in einem PSK-Demodulator gewonnen. Jeder der beiden Teilrahmen (Kanal A, Kanal B) weist ein Synchronisationswort mit 11 Bits auf. Die BCH-Redundanz 31,32 (BCH = Bose Chaudhuri Hocquenghem) ist eine Vielzahl von Parity Bits, die die vorhergehenden Datenwörter 23,25,27,29 bzw. 24,26,28,30 ggfs. korrigiert. Dieser BCH-Code zeigt in Grenzen gleichzeitig an, daß eine Fehlerkorrektur nicht mehr möglich ist. In diesem Fall wird ein Concealment durchgeführt. Concealment bedeutet, Ersatzwerte für fehlerhaft übertragene Abtastwerte zu verwenden. Werden mehrere (mehr als drei) fehlerhafte Abtastwerte hintereinander übertragen, so ist für den Fall, daß auch Synchronisationswerte verfälscht auftreten, von einem gestörten Nachrichtenkanal zu sprechen und damit muß ein neuer Einschwingvorgang gestartet werden.

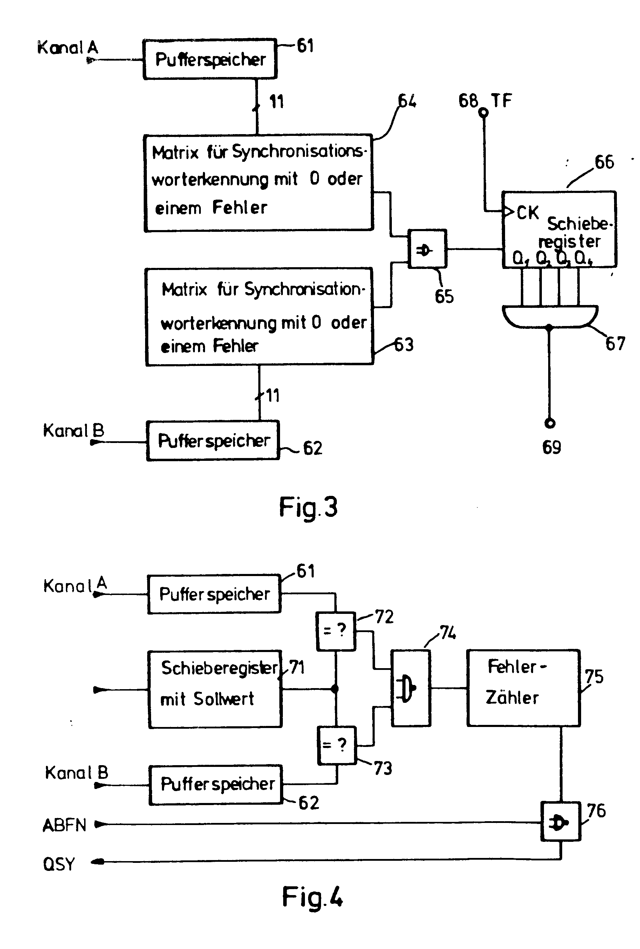

Figur 3 zeigt zwei Pufferspeicher 61,62, zwei Matrizen 63,64, ein Und-Glied 65, ein Schieberegister 66, ein Nand-Glied 67, einen Takteingang 68 für einen Takt TF (Takt zu dem Fenster für ein Synchronisationswort) und einen Ausgang 69. Die Datenfolgen Kanal A und Kanal B werden durch die Pufferspeicher 61,62 geschoben. Die mit den Pufferspeichern 61,62 verbundenen Matrizen 63,64 erkennen die Synchronisationswörter. Die Matrizen 63,64 erkennen die Synchronisationswörter auch dann, wenn diese ein fehlerhaftes Bit aufweisen. Für ein einmaliges Erkennen zweier paralleler Synchronisationswörter in den beiden Teilrahmen Kanal A und Kanal B wird ein Flag-Bit (Zustands Bit) im Schieberegister 66 gesetzt. Im eingeschwungenen Zustand wird das Schieberegister 66 über den Eingang 68 mit dem Taktsignal TF immer dann gestartet und damit das Flag-Bit gesetzt, wenn das Erkennen eines Synchronisationswortes erwartet wird. Die Anzahl der Ausgänge Q1 - Q4 gibt an, wieviele parallele Synchronisationswörter seriell ausfallen müssen, ehe die Synchronisation über das Nand-Glied 67 am Ausgang 69 als nicht mehr vorhanden angezeigt wird.

Figur 4 zeigt ein weiteres Beispiel für die Synchronisationsworterkennung. In einem Schieberegister 71 wird der Sollwert eines Synchronisationswortes geladen. Über die Kanäle A und B ankommende Synchronisationswörter werden in den Pufferspeichern 61 und 62 zwischengespeichert. In Vergleichsgliedern 72 und 73 werden die Synchronisationswörter mit dem Sollwert bitweise verglichen. In einem NandGlied 74 werden fehlerhafte Bits addiert und in einem Fehlerzähler 75 gezählt. Über ein Nor-Glied 76 wird die Anzahl der Fehler abgefragt. Die Abfrage wird über den Eingang ABFN (Abfrage - Fehler in negativer Logik) nach Auswertung des letzten Synchronwortbits ausgelöst. Der Ausgang QSY (Ausgang Synchronwort) zeigt an, ob Synchronisationswörter erkannt worden sind. Die Synchronisationswörter gelten als erkannt, wenn eine vorgegebene Anzahl von fehlerhaften Bits, z.B. 2, nicht überschritten wird.

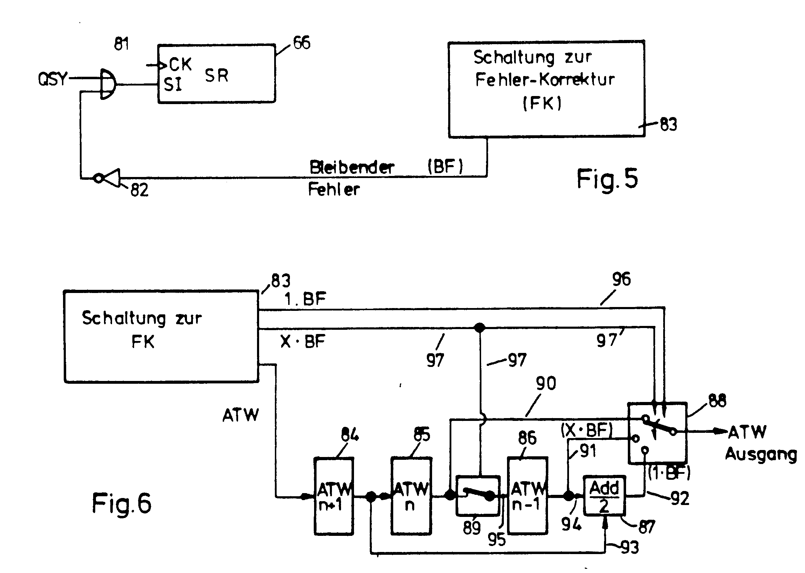

Figur 5 zeigt ein Oder-Glied 81, über das Flag-Bits in einem Schieberegister (66) gesetzt werden. Ein Flag-Bit wird gesetzt, wenn ein Synchronisationswort erkannt worden ist oder wenn ein Datenwort fehlerfrei oder mit korrigierbaren Fehlern erkannt worden ist. Erst bei einem Ausfall eines Synchronisationswortes oder einem mit mehreren Fehlern behafteten Synchronisationswort und einem bleibenden Fehler im Datenwort wird das Flag Bit nicht gesetzt. Die bleibenden Fehler im Datenwort erkennt die Schaltung 83 zur Fehlerkorrektur. Die Meldung der bleibenden Fehler wird über einen Negator 82 an das Oder-Glied 81 gegeben.

Figur 6 zeigt eine Schaltung 83 zur Fehlerkorrektur, Pufferspeicher 84,85 und 86, eine Mittelwertschaltung 87, einen Umschalter 88, einen Ausschalter 89, Datenwortleitungen 90-95 und Steuerleitungen 96 und 97. In den Pufferspeichern 84 - 86 werden aufeinanderfolgende Datenwörter ATW n + 1, n und n - 1 (Abtastwerte n + 1, n und n - 1) zwischengespeichert. Wird von der Fehlerkorrekturschaltung der Abtastwert n als fehlerfrei oder fehlerkorrigierbar erkannt, so wird der Abtastwert n über die Datenwortleitung 90 und den Umschalter 88 auf den Ausgang ATW' gegeben. Wird ein Abtastwert n als nicht mehr korrigierbar erkannt, so wird aus dem vorhergegangenen Abtastwert n - 1 und dem nachfolgenden Wert n + 1 ein Mittelwert in der Schaltung 87 gebildet und dieser Mittelwert wird über den Umschalter 88 auf den

EP 0 195 421 B1

Ausgang ATW' gegeben. Werden mehrere Abtastwerte nacheinander als unkorrigierbar erkannt, so darf der zuletzt als fehlerfrei erkannte und in dem Pufferspeicher 86 zwischengespeicherten Wert nicht gelöscht werden. Die Steuerleitung 97 steuert den Ausschalter 89 so, daß bei mehreren aufeinanderfolgenden unkorrigierbaren Abtastwerten kein unkorrigierbarer Abtastwert in den Pufferspeicher 86 gelangt und der zuletzt noch brauchbare Wert im Pufferspeicher 86 verbleibt. Folgen mehrere unkorrigierbare Abtastwerte aufeinander, so wird über die Leitung 91 und den Umschalter 88 solange der letzte brauchbare Abtastwert auf den Ausgang ATW' gegeben, bis ein fehlerfreier oder korrigierter Wert erscheint. Zur Mittelwertbildung in der Schaltung 87 wird der letzte brauchbare Abtastwert, der in dem Pufferspeicher 86 festgehalten wird, und der nachfolgend erste wieder fehlerfreie bzw. korrigierte Wert herangezogen und an den Ausgang ATW' gelegt. Als nächster Wert wird der neue fehlerfreie Wert an den Ausgang ATW' gelegt. Die Steuerleitungen 96 und 97 steuern den Umschalter 88.

Eine Tabelle zeigt die Wirkung der Schaltung nach Figur 3 R = Richtig F = Falsch)

| 1 . BF | X . BF | ATWn + 1 | ATWn | ATWn-1 | ATW |
|--------|--------|----------|------|--------|-----|
| Nein | Nein | R | R | R | ATWn |
| Nein | Nein | F | R | R | ATWn |
| Ja | Nein | R | F | R | (ATWn + 1  +  ATWn-1) x 1/2 |
| Nein | Nein | F | R | F | ATWn |
| Nein | Ja | F | F | R | ATWn-1 |
| Ja | Nein | R | F | R | (ATWn + 1  +  ATWn-1) x 1/2 |
| Nein | Nein | R | R | F | ATWn |

In der Zeile 1 der Tabelle wird, wenn in den Pufferspeichern 84 - 86 die Abtastwerte ATWn + 1, ATWn und ATWn-1 fehlerfrei oder korrigiert sind, der Abtastwert ATWn an den Ausgang ATW' gelegt. Dabei sind die Steuerleitungen 96 und 97 (1 . BF und X . BF) zu Low gesetzt. In der 2. Zeile wird wieder der Abtastwert ATWn an den Ausgang ATW' gelegt, obwohl der Abtastwert ATWn + 1 unkorrigierbar ist. Werden, wie Zeile 3 zeigt, ein Abtastwert ATWn mit unkorrigierbarem Fehler im Pufferspeicher 85, aber fehlerfreie oder korrigierte Werte in den Pufferspeichern 84 und 86 zwischengespeichert, so gelangt der Mittelwert, der aus den Abtastwerten ATWn + 1 und ATWn-1 gebildet wird, an den Ausgang ATW'. Zelle 4 zeigt, daß ein fehlerfreier oder korrigierter Abtastwert, der im Pufferspeicher 85 steht, an den Ausgang ATW' gelangt, auch wenn die Pufferspeicher 84 und 86 unkorrigierbare Werte beinhalten. Zeile 5 zeigt, daß der letzte brauchbare Abtastwert ATWn-1 im Pufferspeicher 86 festgehalten wird, und an den Ausgang ATW' abgegeben wird, wenn unkorrigierbare Werte in den Pufferspeichern 84 und 85 ankommen. Zeile 3 und 6 sind identisch. Zeile 7 zeigt, daß, wenn ein fehlerfreies oder korrigiertes Datenwort im Pufferspeicher 85 steht, der Schalter 89 wieder zurückgeschaltet werden muß.

Bei einer 4-PSK Demodulation werden pro übertragener Nachrichteneinheit jeweils zwei parallele Bit gewonnen. Diese beiden parallelen Bits werden auf die Kanäle A und B aufgeteilt. Bei der PSK Demodulation treten Phasenfehler auf, die bei differentieller Demodulation einen Doppelfehler zur Folge haben. Doppelfehler bedeutet, daß zwei aufeinanderfolgende Bit falsch decodiert sind. Bei einer fehlerhaften Demodulation zieht ein Fehler im Kanal A automatisch einen weiteren Fehler im Kanal A oder einen Fehler im Kanal B nach sich. Vorteilhaft wird daher im Einschwingvorgang bei der Synchronisationsworterkennung nicht auf jeweils ein Synchronisationswort pro Teilrahmen, sondern auf Synchronisationshalbwörter geprüft.

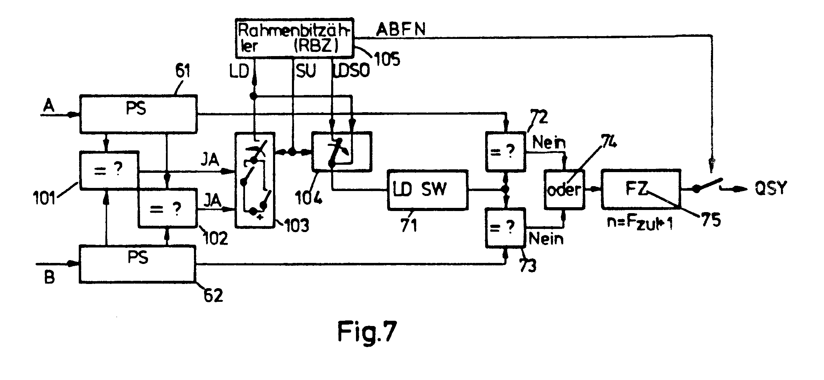

Figur 7 zeigt ein Blockschaltbild der Synchronisationsworterkennung. Über die Kanäle A und B werden Pufferspeicher 61 und 62 mit Synchronisationswörtern geladen. In Matrixanordnungen 101 und 102 werden Synchronisationshalbwörter erkannt, bzw. gesucht. Der Vorgang wird als Suchvorgang bezeichnet. Die Matrixanordnung 101 überprüft die ersten 10 oder 12 Bit beider parallelen Synchronisationswörter, die Matrixanordnung 102 überprüft die letzten 10 oder 12 Bit beider Synchronisationswörter (1 Synchronisationswort = 11 Bit, 1 Synchronisationshalbwort = 5 oder 6 Bit, 2 parallele Synchronisationswörter = 22 Bit, 2 parallele Synchronisationshalbwörter = 10 oder 12 Bit). Während des Einschwingvorgangs reichen zwei Synchronisationshalbworte aus, um über einen Schalter 103 einen Rahmenbitzähler 105 einzuschalten. Vorteilhaft veranlaßt der Rahmenbitzähler 105 über einen Umschalter 104 eine Fehlerüberprüfung der gerade empfangenen Synchronisationsworte. Die fehlerüberprüfung mit dem Schieberegister 71, mit den Vergleichsgliedern 72,73, dem Oder-Glied 74 und dem Fehlerzähler 75 ist bereits in der Figur 4 beschrieben. Der Rahmenbitzähler 105 und die Schalter 103 und 104 wirken so zusammen, daß während des Einschwingvorganges Synchronisationshalbwörter erkannt werden und auf die Schaltungsteile 71 - 75 zur Synchronisationsworterkennung umgeschaltet wird. Auf den eingeschwungenen Zustand wird nach Erkennen eines Synchronisationshalbwortes und nach Erkennen zweier aufeinanderfolgender paralleler Synchroni-

4

sationswörter umgeschaltet. Im eingeschwungenen Zustand wird auf das Ergebnis der Überprüfung von Synchronisationshalbwörtern in den Matrixanordnungen 101,102 verzichtet. Wenn ein Synchronisationswort erwartet wird, lädt der Rahmenbitzähler 105 das Schieberegister mit dem Sollwert und schaltet am Ende eines Synchronisationswortes über die Leitung ABFN das Ergebnis der Überprüfung von Zähler 75 auf den Ausgang QSY. Gleichzeitig führt der Rahmenbitzähler eine Rückverwürfelung (Descrambling) durch. Unter anderem wird aufgrund der Synchronisierungsschwierigkeit im Empfänger, die eine ununterbrochene Serie von Nullen oder eine ununterbrochene Serie von Einsen auslöst, eine Verwürfelung derart durchgeführt, daß immer genügend Wechsel von Nullen zu Einsen und Einsen zu Nullen vorhanden sind, um eine Taktsynchronisierung empfängerseitig sicherzustellen. Dazu ist empfängerseitig ein Descrambler (Rückverwürfler) und senderseitig ein Scrambler (Verwürfler) vorhanden.

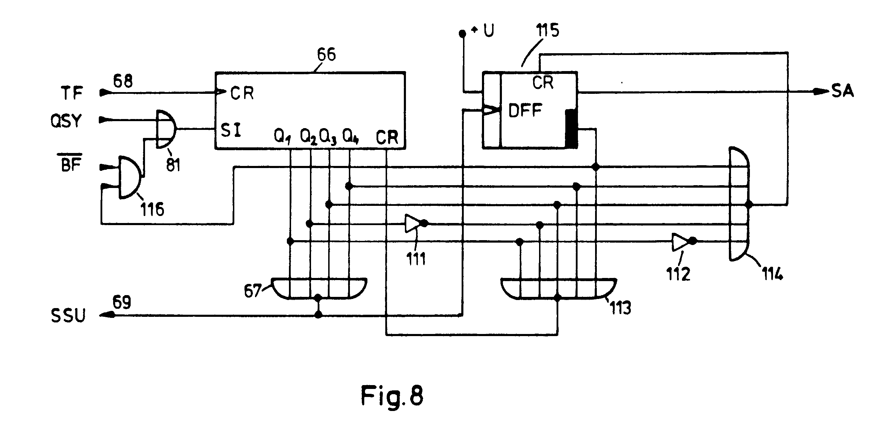

Figur 8 zeigt das Schieberegister 66, ein Nor-Glied 67, einen Eingang 68 für ein Signal TF, einen Ausgang 69 für ein Signal SSU (Synchronisationswort suchen), Eingänge für Signale QSY und Stop und das negative BF Signal, ein Oder-Glied 81, Negatoren 111 und 112, Nor-Glieder 113 und 114, ein D-FF (Delay-Flip-Flop) 115, ein Und-Glied 116 und einen Ausgang SA. Über den Eingang SI werden Flag Bits in das Schieberegister 66 geschoben. Diese Flag Bits zeigen an, ob eine Synchronisation vorliegt. Im eingeschwungenen Zustand ist das Und-Glied 116 über den Stop-Eingang freigeschaltet und über das Oder-Glied 81 kann ein Flag Bit gesetzt werden, wenn ein Datenwort fehlerfrei oder fehlerkorrigiert vorliegt oder wenn zwei parallele Synchronisationswörter erkannt sind. Im Einschwingvorgang wird das Und-Glied vom Stop-Eingang gesperrt, das Datenwort wird nicht zur Synchronisation zugelassen. Im eingeschwungenen Zustand zeigen die Ausgänge Q1 bis Q4 anhand von seriellen Flag-Bits den Zustand der Synchronisation des aktuellen Hauptrahmens und drei vorhergegangener Hauptrahmen an. Kann in vier Hauptrahmen nacheinander keine Synchronisation festgestellt werden, so wird über das Nor-Glied 67 und dem Ausgang 69 mit dem Signal SSU eine neue Synchronisationswortsuche ausgelöst.

Zu Beginn des Suchvorgangs steht das Nor-Glied 67 über den Takteingang das D-FF 115 auf Q = log 1. Zwei erkannte aufeinanderfolgende Synchronisationswörter setzen im Einschwingvorgang über das Nor-Glied 114 das D-FF (Delay-Flip-Flop) 115, das den Zustand Einschwingvorgang bzw. eingeschwungener Zustand anzeigt, auf den eingeschwungenen Zustand. Das würde als erfolgreiche Fensterprüfung bezeichnet. Folgen beim Suchvorgang auf die ersten beiden parallelen Synchronisationswörter bei der ersten Fensterprüfung keine zweiten parallelen Synchronisationswörter, so spricht das Nor-Glied 113 an, das das Schieberegister 66 zurücksetzt und einen neuen Suchvorgang auslöst.

## Patentansprüche

1. Verfahren zur Synchronisation von digitalen Informationssignalen in einem Empfänger (6, 7), insbesondere für Satellitenrundfunk, bei dem Synchronisationswörter (21, 22, 51, 52) und Datenwörter (23 - 50) in regelmäßigen Zeitabschnitten (Hauptrahmen) übertragen werden, wobei die Synchronisationswörter und/oder Datenwörter eine gleichbleibende Codewortlänge aufweisen und für die Datenwortübertragung ein fehlerkorrigierender Code (BCH) verwendet wird, bei dem in einem Einschwingvorgang ein Suchvorgang zur Auffindung der Synchronisationswörter gestartet wird und bei dem in einem eingeschwungenen Zustand zu einer Synchronisationsüberwachung gewechselt wird, dadurch gekennzeichnet, daß die Synchronisationsüberwachung eine Prüfung der Synchronisationswörter (21, 22, 51, 52) und eine Prüfung der Fehlerhäufigkeit von übertragenen Datenwörtern (23 - 50) gemeinsam auswertet, daß im eingeschwungenen Zustand in eine Neusynchronisation gewechselt wird, wenn ein Datenwort nicht mehr korrigiert werden kann und mehrere aufeinanderfolgende Synchronworte als falsch erkannt werden, und daß im Suchvorgang zur schnellen Auffindung eines Synchronisationswortes vorzugsweise nur Teile eines Synchronisationswortes, z.B. Synchronisationshalbworte geprüft werden.

2. Verfahren nach Anspruch 1, dadurch gekennzeichnet, daß der eingeschwungene Zustand beibehalten wird, wenn eine begrenzte Anzahl von Fehlern in den Synchronisationswörtern (21,22,51,52) vorliegt.

3. Verfahren nach Anspruch 1, dadurch gekennzeichnet, daß der eingeschwungene Zustand beibehalten wird, wenn eine begrenzte Anzahl von aufeinanderfolgenden Synchronisationswörtern (21,22,51,52) ausfällt.

4. Verfahren nach Anspruch 1, dadurch gekennzeichnet, daß der eingeschwungene Zustand beibehalten wird, wenn eine begrenzte Anzahl von aufeinanderfolgenden Synchronisationswörtern (21,22,51,52) eine begrenzte Anzahl von Fehlern aufweist und/oder ausfällt.

**5.** Verfahren nach einem oder mehreren der vorhergehenden Ansprüche, dadurch gekennzeichnet, daß der eingeschwungene Zustand beibehalten wird, wenn ein oder mehrere unkorrigierbare Datenwörter (23-50) empfangen werden.

**6.** Verfahren nach Anspruch 5, dadurch gekennzeichnet, daß für ein oder mehrere unkorrigierbare Datenwörter (23-50) ein oder mehrere Concealments (Figur 6) durchgeführt werden.

**7.** Verfahren nach einem oder mehreren der vorhergehenden Ansprüche, dadurch gekennzeichnet, daß vom Einschwingvorgang in den eingeschwungenen Zustand gewechselt wird, wenn zwei oder mehrere Synchronisationswörter (21,22,51,52) nacheinander in regelmäßigen Zeitabschnitten gefunden werden.

**8.** Verfahren nach einem oder mehreren der vorhergehenden Ansprüche, dadurch gekennzeichnet, daß vom Einschwingvorgang in den eingeschwungenen Zustand gewechselt wird, wenn einmal oder mehrmals nacheinander die Synchronisationswörter (21,22,51,52) und/oder fehlerfreie oder fehler-korrigierbare Datenwörter (23-50) empfangen werden.

**9.** Verfahren nach Anspruch 7 oder 8, dadurch gekennzeichnet, daß eine begrenzte Anzahl von Fehlern in den Synchronisationswörtern (21,22,51,52) zugelassen ist.

**10.** Vorrichtung zur Synchronisation von digitalen Informationssignalen in einem Empfänger (6, 7), insbesondere für Satellitenrundfunk, bei dem Synchronisationswörtern (21, 22, 51, 52) und Datenwörter (23 - 50) in regelmäßigen Zeitabschnitten (Hauptrahmen) übertragen werden, wobei die Synchronisationswörter und/oder Datenwörter eine gleichbleibende Codewortlänge aufweisen und für die Datenwortübertragung ein fehlerkorrigierender Code (BCH) verwendet wird, bei dem in einem Einschwingvorgang ein Suchvorgang zur Auffindung der Synchronisationswörter gestartet wird und bei dem in einem eingeschwungenen Zustand zu einer Synchronisationsüberwachung gewechselt wird, **dadurch gekennzeichnet**, daß die Vorrichtung eine Synchronisations-Überwachungseinheit (10) zur Prüfung der Synchronisationswörter (21, 22; 51, 52) mit einem Synchronisationswort-Detektor (9) sowie einem Datenwort-Decoder (8) zur Prüfung der Fehlerhäufigkeit von übertragenen Datenwörtern (23 - 50) enthält, daß der Synchronisationswort-Detektor (9) eine Schaltung (61, 62, 63, 64, 65; 101, 102,103) zum Erkennen der Synchronisationswörter beinhaltet, und das im eingeschwungenen Zustand in eine Neusynchronisation gewechselt wird, wenn ein Datenwort nicht mehr korrigiert werden kann und mehrere aufeinanderfolgende Synchronworte in dem Decoder (9) als falsch erkannt werden.

**11.** Vorrichtung nach Anspruch 10, dadurch gekennzeichnet, daß ein Schieberegister (66) den Zustand von Fehlerhäufigkeiten der Synchronisationswörter und/oder Datenwörter in den letzten n Zeitabschnitten (Hauptrahmen) abspeichert.

**12.** Vorrichtung nach Anspruch 10 oder 11, dadurch gekennzeichnet, daß eine Schaltung (83) zur Fehlerkorrektur vorgesehen ist.

**13.** Vorrichtung nach Anspruch 12, dadurch gekennzeichnet, daß die Schaltung (83) eine Schaltung (84-89) zur Bildung von Concealments steuert.

**14.** Vorrichtung nach einem oder mehreren der Ansprüche 10 bis 13, dadurch gekennzeichnet, daß ein Flip-Flop (115) den Zustand Einschwingvorgang oder eingeschwungener Zustand abspeichert.

**15.** Vorrichtung nach einem oder mehreren der Ansprüche 10 bis 14, dadurch gekennzeichnet, daß ein Rahmenbitzähler (105) vorgesehen ist, der die Anzahl der Bits in den Rahmen zählt.

**16.** Vorrichtung nach einem oder mehreren der Ansprüche 10 bis 15, dadurch gekennzeichnet, daß der Rahmenbitzähler (105) eine Rückverwürfelung durchführt.

**Claims**

**1.** A process for the synchronisation of digital information signals in a receiver (6, 7), in particular for satellite broadcasting, wherein synchronising words (21, 22, 51, 52) and data words (23-50) are transmitted in regular time (main frame) periods, wherein the synchronising words and/or data words possess a uniform code word length and an error-correcting code (BCH) is used for the data word transmission, wherein in a build-up process a search procedure is started to find the synchronising words and wherein in a steady state a change-over is made to synchronisation monitoring, characterised in that the synchronisation monitoring jointly analyzes a check of the synchronising words (21, 22, 51, 52) and a check of the error rate of transmitted data words (23 - 50), that in the steady state a change-over is made to resynchronisation when a data word can no longer be corrected and a plurality of consecutive synchronising words are recognised as being incorrect, and that in the search procedure to rapidly find a synchronising word preferably only parts of a synchronising word, e.g. synchronising halfwords, are checked.

2. A process as claimed in claim 1, characterized in that the steady state is maintained when a limited number of errors are present in the synchronising words (21, 22, 51, 52).

3. A process as claimed in claim 1, characterized in that the steady state is maintained when a limited number of consecutive synchronising words (21, 22, 51, 52) are absent.

4. A process as claimed in claim 1, characterized in that the steady state is maintained when a limited number of consecutive synchronising words (21, 22, 51, 52) possess a limited number of errors and/or are absent.

5. A process as claimed in one or more of the preceding claims, characterized in that the steady state is maintained when one or more uncorrectable data words (23 - 50) are received.

6. A process as claimed in claim 5, characterized in that one or more concealments (Figure 6) are performed for one or more uncorrectable data words (23 - 50).

7. A process as claimed in one or more of the preceding claims, characterised in that a change-over is made from the build-up process into the steady state when two or more synchronising words (21, 22, 51, 52) are found consecutively in regular time periods.

8. A process as claimed in one or more of the preceding claims, characterized in that a change-over is made from the build-up process into the steady state when the synchronising words (21, 22, 51, 52) and/or error-free or error-correctable data words (23 - 50) are received once or several times in succession.

9. A process as claimed in Claim 7 or 8, characterized in that a limited number of errors are permitted in the synchronising words (21, 22, 51, 52).

10. A device for the synchronisation of digital information signals in a receiver (6, 7), in particular for satellite broadcasting, wherein synchronising words (21, 22, 51, 52) and data words (23 - 50) are transmitted in regular time (main frame) periods , wherein the synchronising words and/or data words possess a uniform code word length and an error-correcting code (BCH) is used for the data word transmission, wherein in a build-up process a search procedure is started to find the synchronising words and wherein in a steady state a change-over is made to synchronisation monitoring, characterised in that the device comprises a synchronisation monitoring unit (10) for checking the synchronising words (21, 22, 51, 52) with a synchronising word detector (9) and with a data word decoder (8) for checking the error rate of transmitted data words (23 - 50), that the synchronising word detector (9) comprises a circuit (61, 62, 63, 64, 65; 101, 102, 103) for recognising the synchronising words, and that in the steady state a change-over is made to resynchronisation when a data word can no longer be corrected and a plurality of consecutive synchronising words are recognized as incorrect in the decoder (9).

11. A device as claimed in claim 10, characterized in that a shift register (66) stores the state of error rates of the synchronising words and/or data words in the last n time periods (main frame).

12. A device as claimed in Claim 10 or 11, characterised in that a circuit (83) is provided for the error correction.

EP 0 195 421 B1

**13.** A device as claimed in Claim 12, characterized in that the circuit (83) controls a circuit (84 - 89) for the formation of concealments.

**14.** A device as claimed in one or more of Claims 10 to 13, characterized in that a flip-flop (115) stores the build-up process state or the steady state.

**15.** A device as claimed in one or more of Claims 10 to 14, characterized in that a frame bit counter (105) is provided which counts the number of bits in the frames.

**16.** A device as claimed in one or more of Claims 10 to 15, characterized in that the frame bit counter (105) carries out descrambling.

**Revendications**

**1.** Procédé pour la synchronisation de signaux d'information numériques dans un récepteur (6, 7), en particulier pour la radiodiffusion par satellite, dans lequel des mots de synchronisation (21, 22, 51, 52) et des mots contenant des données (23 - 50) sont transmis à intervalles de temps réguliers (cadre principal), les mots de synchronisation et/ou mots contenant des données présentant une longueur de mot de code constante et un code correcteur d'erreurs (code BCH) étant utilisé pour la transmission du mot contenant des données, dans lequel une opération de recherche est démarrée pendant un phénomène transitoire pour rechercher des mots de synchronisation et dans lequel il y a, pendant un régime permanent, changement à un contrôle de la synchronisation, **caractérisé en ce** que le contrôle de la synchronisation exploite en commun une vérification des mots de synchronisation (21, 22, 51, 52) et une vérification du taux d'erreurs des mots contenant des données transmis (23 - 50), qu'en régime permanent il y a changement en une nouvelle synchronisation lorsqu'un mot contenant des données ne peut plus être corrigé et que plusieurs mots de synchronisation successifs sont reconnus comme étant incorrects et qu'en opération de recherche, pour chercher rapidement un mot de synchronisation, de préférence seulement des parties d'un mot de synchronisation, par exemple des demi-mots de synchronisation, sont vérifiés.

**2.** Procédé selon la revendication 1, **caractérisé en ce** que le régime permanent est gardé lorsqu'il y a un nombre limité d'erreurs dans les mots de synchronisation (21, 22, 51, 52).

**3.** Procédé selon la revendication 1, **caractérisé en ce** que le régime permanent est gardé lorsqu'un nombre limité de mots de synchronisation successifs (21, 22, 51, 52) fait défaut.

**4.** Procédé selon la revendication 1, **caractérisé en ce** que le régime permanent est gardé lorsqu'un nombre limité de mots de synchronisation successifs (21, 22, 51, 52) présente un nombre limité d'erreurs et/ou fait défaut.

**5.** Procédé selon l'une ou plusieurs des revendications précédentes, **caractérisé en ce** que le régime permanent est gardé lorsqu'un ou plusieurs mots contenant des données (23 - 50) incorrigibles sont reçus.

**6.** Procédé selon la revendication 5, **caractérisé en ce** qu'un ou plusieurs concealments (figure 6) sont effectués pour un ou plusieurs mots contenant des données incorrigibles (23-50).

**7.** Procédé selon l'une ou plusieurs des revendications précédentes, **caractérisé en ce** qu'il y a changement du phénomène transitoire au régime permanent lorsque deux ou plusieurs mots de synchronisation (21, 22, 51, 52) sont trouvés successivement à des intervalles de temps réguliers.

**8.** Procédé selon l'une ou plusieurs des revendications précédentes, **caractérisé en ce** qu'il y a changement du phénomène transitoire au régime permanent lorsqu'une ou plusieurs fois successives les mots de synchronisation (21, 22, 51, 52) et/ou des mots contenant des données exempts d'erreurs ou à erreurs corrigibles (23-50) sont reçus.

**9.** Procédé selon la revendication 7 ou 8, **caractérisé en ce** qu'un nombre limité d'erreurs est admis dans les mots de synchronisation (21, 22, 51, 52).

8

**10.** Dispositif pour la synchronisation de signaux d'information numériques dans un récepteur (6, 7), en particulier pour la radiodiffusion par satellite, dans lequel des mots de synchronisation (21, 22, 51, 52) et des mots contenant des données (23 - 50) sont transmis à intervalles de temps réguliers (cadre principal), les mots de synchronisation et/ou mots contenant des données présentant une longueur de mot de code constante et un code correcteur d'erreurs (code BCH) étant utilisé pour la transmission du mot contenant des données, dans lequel une opération de recherche est démarrée pendant un phénomène transitoire pour rechercher des mots de synchronisation et dans lequel il y a, pendant un régime permanent, changement à un contrôle de la synchronisation, **caractérisé en ce** que le dispositif contient une unité de contrôle de la synchronisation (10) pour la vérification des mots de synchronisation (21, 22 ; 51, 52) avec un détecteur de mot de synchronisation (9) ainsi qu'avec un décodeur de mot contenant des données (8) pour vérifier le taux d'erreurs de mots contenant des données transmis (23 50), que le détecteur de mots de synchronisation (9) contient un circuit (61, 62, 63, 64, 65 ; 101, 102, 103) pour reconnaître les mots de synchronisation et qu'il y a changement en régime permanent en une nouvelle synchronisation lorsqu'un mot contenant des données ne peut plus être corrigé et que plusieurs mots de synchronisation successifs sont reconnus dans le décodeur (9) comme étant incorrects.

**11.** Dispositif selon la revendication 10, **caractérisé en ce** qu'un registre à décalage (66) met en mémoire l'état du taux d'erreurs des mots de synchronisation et/ou des mots contenant des données dans les n derniers intervalles de temps (cadres principaux).

**12.** Dispositif selon la revendication 10 ou 11, **caractérisé en ce** qu'un circuit (83) est prévu pour la correction d'erreurs.

**13.** Dispositif selon la revendication 12, **caractérisé en ce** que le circuit (83) commande un circuit (84-89) pour former des concealments.

**14.** Dispositif selon l'une ou plusieurs des revendications 10 à 13, **caractérisé en ce** qu'une bascule (115) mémorise l'état phénomène transitoire ou régime permanent.

**15.** Dispositif selon l'une ou plusieurs des revendications 10 à 14, **caractérisé en ce** qu'un compteur de bits de cadre (105), qui compte le nombre des bits dans le cadre, est prévu.

**16.** Dispositif selon l'une ou plusieurs des revendications 10 à 15, **caractérisé en ce** que le compteur des bits de cadre (105) effectue un désembrouillage.

Nachrichtenquelle — 1

Wandler — 2

Sendegerät — 3

Nachrichtenkanal — 4

Störung S(t) — 5

Empfangsgerät — 6

Decoder für Datenwörter

Detektor für Synchronisationswörter

8    9    Überwachungseinheit für Synchronisation

10    Wandler

7

Nachrichtensinke

11

Fig.1

Fig. 2

EP 0 195 421 B1

EP 0 195 421 B1

Kanal A → Pufferspeicher — 61

11

Matrix für Synchronisationsworterkennung mit 0 oder
einem Fehler — 64

68 TF

66

CK Schieberegister
$Q_1$ $Q_2$ $Q_3$ $Q_4$

65

Matrix für Synchronisationworterkennung mit 0 oder
einem Fehler — 63

67

11

Kanal B → Pufferspeicher — 62

69

Fig.3

Kanal A → Puffer speicher — 61

= ? — 72

74

Schieberegister — 71
mit Sollwert

Fehler-
Zähler — 75

= ? — 73

Kanal B → Puffer speicher — 62

ABFN — 76

QSY

Fig.4

12

Fig.5

Fig.6

EP 0 195 421 B1

Fig.7

Fig.8

EP 0 195 421 B1